# EUROPEAN PATENT SPECIFICATION

(11) **EP 0 459 773 B1**
(45) Date of publication and mention of the grant of the patent: **04.04.2001**
(21) Application number: 91304831.0
(22) Date of filing: 29.05.1991
(51) Int. Cl.: H01L 21/8238, H01L 21/285

(54) **Method of producing a semiconductor integrated circuit having complementary field effect transistors**
Verfahren zur Herstellung einer integrierten Halbleiterschaltungsanordnung mit komplementären Feldeffekttransistoren
Procédé de réalisation d'un circuit semiconducteur intégré à transistors complémentaires à effet de champ

(30) Priority: 31.05.1990 JP 13961290
(43) Date of publication of application: 04.12.1991
(73) Proprietor: CANON KABUSHIKI KAISHA, Tokyo (JP)
(72) Inventor: Yuzurihara, Hiroshi, c/o Canon Kabushiki Kaisha, Ohta-ku, Tokyo (JP); Inoue, Shunsuke, c/o Canon Kabushiki Kaisha, Ohta-ku, Tokyo (JP); Miyawaki, Mamoru, c/o Canon Kabushiki Kaisha, Ohta-ku, Tokyo (JP); Matsumoto, Shigeyuki, c/o Canon Kabushiki Kaisha, Ohta-ku, Tokyo (JP)
(74) Representative: Beresford, Keith Denis Lewis

(56) References cited:
- EP-A- 0 098 737
- EP-A- 0 123 309
- EP-A- 0 163 132
- EP-A- 0 420 594
- DE-A- 2 537 564
- US-A- 4 328 261
- PATENT ABSTRACTS OF JAPAN vol. 9, no. 106 (E-313)10 May 1985 & JP 59 231 871 A ( NIPPON DENKI KK ) 26 December 1984
- Japanese Journal of Applied Physics, vol. 27, no. 8, August 1988, Tokyo, pages L1392 - L1394
- PATENT ABSTRACTS OF JAPAN vol. 08, no. 155 (E-256) 19 July 1984 & JP 59 057 469 A (FUJITSU KK) 03 April 1984
- HANABUSA ET AL.: 'Photochemical Vapor Deposition of Aluminum Thin Films Using Dimethylaluminum Hydride' J.J. APPL. PHYS. vol. 27, no. 8, August 1988, TOKYO, pages L1392 - L1394

## Description

The present invention concerns a method of producing a silicon semiconductor integrated circuit, for example a memory or a signal processing device, for use in various electronic appliances. It is concerned, in particular, with a method of producing a silicon semiconductor integrated circuit having complementary P-channel and N-channel insulated gate field effect transistors (IGFETS) defined on a silicon semiconductor substrate, the insulated gate electrodes of those transistors being of opposite conductivity type doped polycrystalline or monocrystalline silicon semiconductor materials, which insulated gate electrodes extend and meet at a semiconductor pn or pin junction, there being a patterned shunt layer of a thin film metallic material provided over the entire area of said insulated gate electrodes, which method comprises the following steps:
providing the silicon semiconductor substrate and a gate insulation film on its surface,
producing a polycrystalline or monocrystalline silicon semiconductor layer on said gate insulation film, which crystalline silicon semiconductor layer is patterned and doped to define the adjoined gate electrodes of respective opposite conductivity types; and
forming the patterned shunt layer of thin film metallic material over the entire area of said gate electrodes.

Doped polysilicon has been used as a wiring material for various semiconductor devices, a gate material for an IGFET, or an impurity diffusion source. Such doped polysilicon has contained the impurity of a single conductivity type, in consideration of ease of manufacturing process.

However, when, for example, polysilicon is used as the gate material of complementary P-channel and N-channel insulated gate field effect transistors (IGFETs) of conventional structure, and the gate electrodes are of the same conductive type material, such as n-polysilicon, the threshold voltages of the two transistors are not mutually matched.

Silicon semiconductor integrated circuits, of the type defined in the introduction, having polysilicon gate electrodes of opposite conductivity type, preferably of the same conductivity types as the channels thereunder, avoid this problem and examples are given in Patent Abstracts of Japan, vol.8, No. 155 (E-256) 19th July 1984 and Japanese Kokai JP-A-59057469, and European Patent Application EP-A-0098737.

In particular, the latter reference discloses an integrated circuit in which a thin film metallic shunt layer of either molybdenum silicide or tungsten silicide is formed over the entire area of the adjoined gate electrodes. Method steps disclosed therein, which are the same as those performed in the present invention, are recited in the preamble of claim 1 appended.

In accordance with the present invention the method of producing the integrated circuit is characterised in that the shunt layer is formed by a selective chemical vapour deposition process wherein an aluminium metallic material is deposited selectively over the entire area of the adjoined gate electrodes by exposing the adjoined gate electrodes, and the surface of the gate insulation film surrounding the adjoined gate electrodes, to a chemical vapour ambient comprising an alkyl aluminium hydride, selected from either monomethylaluminium hydride or dimethylaluminium hydride, as aluminium source, and hydrogen, introduced from an external source, which chemical vapour ambient is at a temperature which is at least equal to the decomposition temperature of said alkyl aluminium hydride but is lower than 450°C.

The semiconductor material of gate electrodes and interconnecting wiring conveniently may be of polysilicon. In preference to this, however, monocrystalline silicon can be used with the advantage of greater migration resistance.

A metal silicide film may be interposed between the silicon semiconductor gate electrode and the thin film aluminium layer metallic shunt aforesaid.

European Patent Application EP-A-0163132, mentioned here by way of acknowledgment, discloses an integrated circuit in which electrodes, other than gate electrodes, of polysilicon semiconductor material doped p-type and n-type, respectively have extended patterns of polysilicon providing interconnective wiring. These electrodes and the interconnective wiring are shunted by a co-extensive layer of tungsten metal which not only serves to reduce resistance but also serves to eliminate the effect of a pn junction defined in the interconnective polysilicon wiring. The gate electrodes of both p-channel and n-channel transistors are of n⁺-type polysilicon - i.e. all of the same conductivity type.

It is also acknowledged that laminated wiring, in particular aluminium or aluminium-based metal laminated on polysilicon is known. See for example: European Patent Application EP-A-0123309; Patent Abstracts of Japan, vol.9, No. 106 (E-313) 10 May 1985, and Japanese Kokai JP-A-59231871.

Selective deposition of aluminium using a chemical vapour deposition ambient comprising dimethylaluminium hydride, is also known. Japanese Journal of Applied Physics, Vol.27, No. 8, August 1988, Tokyo, pages L1392-L1394 describes a selective process in which a substrate is exposed to an ambient of dimethyl aluminium hydride. At temperatures below 240°C, aluminium is selectively deposited only on that area of the substrate surface that is illuminated with an energetic ultraviolet beam. It is necessary to control the position of the beam so that only a desired area is illuminated.

US-A-4 328 261 describes a CVD method based an aluminium alkyls and silane, with optional and dilution with hydrogen.

Preferred embodiments of the present invention will now be detailed, by way of example, making reference to the following drawings:
Figs. 1A and 1B are schematic views to show the laminated structure of a polysilicon layer and a metallic shunt layer;
Figs. 2 to 5 are views showing examples of apparatus suitable for performing the method of the present invention;
Figs. 6A to 6D are schematic perspective views showing steps for forming a wiring layer;
Figs. 7 and 8 respectively are a schematic cross-sectional view and a schematic plan view of complementary P-channel and N-channel IGFETs;
Figs. 9 to 12 are schematic cross-sectional views showing the production method thereof;
Fig. 13 is a circuit diagram of an inverter circuit;
Figs. 14 to 16 are views showing laminate structures;
Fig. 17 is a plan view of complementary IGFETs obtained by a conventional method.

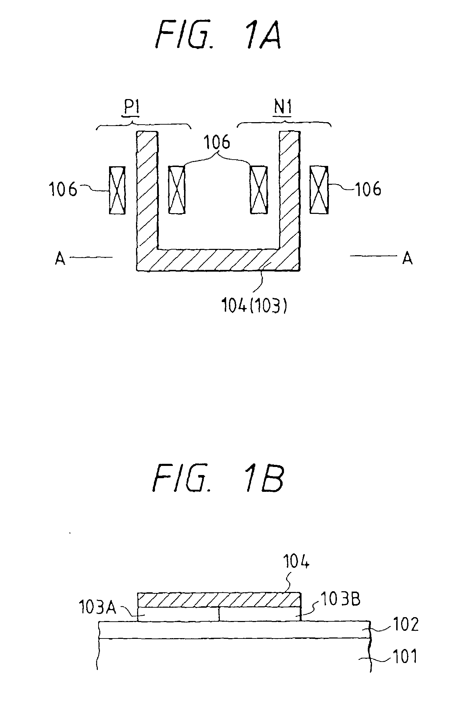

Figs. 1A and 1B respectively are a plan view and a cross-sectional view along a line A-A in Fig. 1A, schematically showing complementary IGFETs having a laminate structure of a polysilicon layer and a metallic layer. On a semiconductor substrate 101, there are formed a P-channel IGFET (P1) and an N-channel IGFET (N1). On an oxide film 102, there is formed a laminate electrode wiring consisting of a single polysilicon layer 103 and a metallic layer 104, serving as the gate electrodes and wirings for both devices, and source-drain electrodes 106 are further formed. Said single polysilicon layer 103 is doped p-type in a portion 103A on the P-channel side of the device, and n-type in a portion 103B on the N-channel side of the device and, on the entire area of the polysilicon layer, there is deposited selectively an aluminium metallic layer 104. A multi-layered wiring may also be obtained by opening a through-hole in an arbitrary position in an insulation film (not shown) formed on the metallic wiring layer 104, selectively depositing a metal in said through-hole, and forming another wiring on said insulation film.

More specifically, a laminate structure of an aluminium metallic material and polycrystalline or monocrystalline silicon can be obtained by the selective deposition of the aluminium metallic material on a patterned layer of the crystalline silicon. A multi-layered wiring structure can be obtained by effecting the selective deposition and then a non-selective deposition.

Examples of aluminium metallic materials that can be deposited selectively include aluminium metal, aluminium mixed metal alloys, e.g. Al-Ti and Al-Cu and aluminium silicides, e.g. Al-Si, Al-Si-Ti and Al-Si-Cu. A silicide layer may be formed on the polysilicon prior to selective deposition of the metallic film.

The doping of the polysilicon layer may be conducted in the ion implantation steps for forming the source-drain areas of each IGFET, or in other separate steps.

Also the lead electrode for the source-drain area may be composed of a multi-layered film composed of polysilicon and Al-Si.

### [Film forming method]

In the following there will be explained a film forming method, suitable for forming an electrode.

This film forming method consists of forming a deposited film by a surface reaction on an electron donating substrate, utilizing alkylaluminium hydride gas and hydrogen gas (said method being hereinafter called Al-CVD method). An aluminium film of satisfactory quality can be deposited by heating the surface of the substrate in the presence of a gaseous mixture particularly consisting of monomethylaluminium hydride (MMAH) or dimethylaluminium hydride (DMAH) as the source material gas and hydrogen . At the selective Al deposition, the substrate surface is maintained at a temperature at least equal to the decomposition temperature of alkylaluminium hydride but lower than 450°C, more preferably between 260°C and 440°C, by direct or indirect heating.

The heating of the substrate in the above-mentioned temperature range may be achieved by direct or indirect heating, but formation of an Al film of satisfactory quality can be achieved with a high deposition speed, particularly by direct heating. For example, with the more preferred temperature range of 260° - 440°C, a satisfactory film can be obtained with a deposition speed of 30-500 nm/min (300-5000 Å/min) which is higher than in the resistance heating. Such direct heating (substrate being heated by direct transmission of energy from the heating means) can be achieved by heating with a lamp such as a halogen lamp or a xenon lamp. Also indirect heating may be achieved for example by resistance heating, conducted by a heat generating member provided in a substrate support member, for supporting the substrate to be subjected to film deposition, provided in a film depositing space.

This method, if applied to a substrate having both an electron donating surface area and an electron non-donating surface area, allows to form single crystal of aluminium with satisfactory selectivity solely on the electron donating surface area. Such aluminium is excellent in all the properties required for electrodes and for wiring material, including a low hillock frequency and a low alloy spike frequency.

This is presumably because the semiconductive or conductive surface constituting an electron donating surface can selectively develop an aluminium film of satisfactory quality and excellent crystalline character of said Al film excludes or significantly reduces the alloy spike formation etc. resulting from an eutectic reaction with the underlying silicon.

As explained above, the Al deposited in an aperture with an electron donating surface, for example an aperture formed in an insulating film and exposing the surface of a semiconductor substrate therein, has a monocrystalline structure. Besides said Al-CVD method can achieve selective deposition of the following aluminium metallic films, with likewise satisfactory quality.

For example, the electrode may be formed by selective deposition of various conductive materials such as Al-Si, Al-Ti, Al-Cu, Al-Si-Ti or Al-Si-Cu by the use of a mixed gaseous atmosphere employing, in addition to alkylaluminium hydride gas and hydrogen, a suitable combination of:
Si-containing gas such as SiH₄, Si₂H₆, Si₃H₈, Si (CH₃) ₄, SiCl₄, SiH₂Cl₂ or SiHCl₃;
Ti-containing gas such as TiCl₄, TiBr₄ or Ti(CH₃)₄; and/or
Cu-containing gas such as copper bisacetylacetonate Cu(C₅H₇O₂)₂, copper bisdipyvaloylmethanite Cu (C₁₁H₁₉O₂)₂ or copper bishexafluoroacetylacetonate Cu (C₅HF₆O₂)₂.

Also since said Al-CVD method is excellent in selectivity and provides satisfactory surface characteristics on the deposited film, there can be obtained a metallic film suitable and widely usable for the wirings of a semiconductor device, by employing a non-selective film forming method in a next deposition step to form an aluminium metallic film not only on the selectively deposited aluminium metallic film mentioned above but also on the SiO₂ insulation film.

Examples of such metallic films include combinations of selectively deposited Al, Al-Si, Al-Ti, Al-Cu, Al-Si-Ti or Al-Si-Cu and non-selectively deposited Al, Al-Si, Al-Ti, Al-Cu, Al-Si-Ti or Al-Si-Cu. Said non-selective film deposition may be achieved by CVD other than the aforementioned Al-CVD, or by sputtering.

### [Film forming apparatus]

In the following there will be explained a film forming apparatus suitable for the electrode formation.

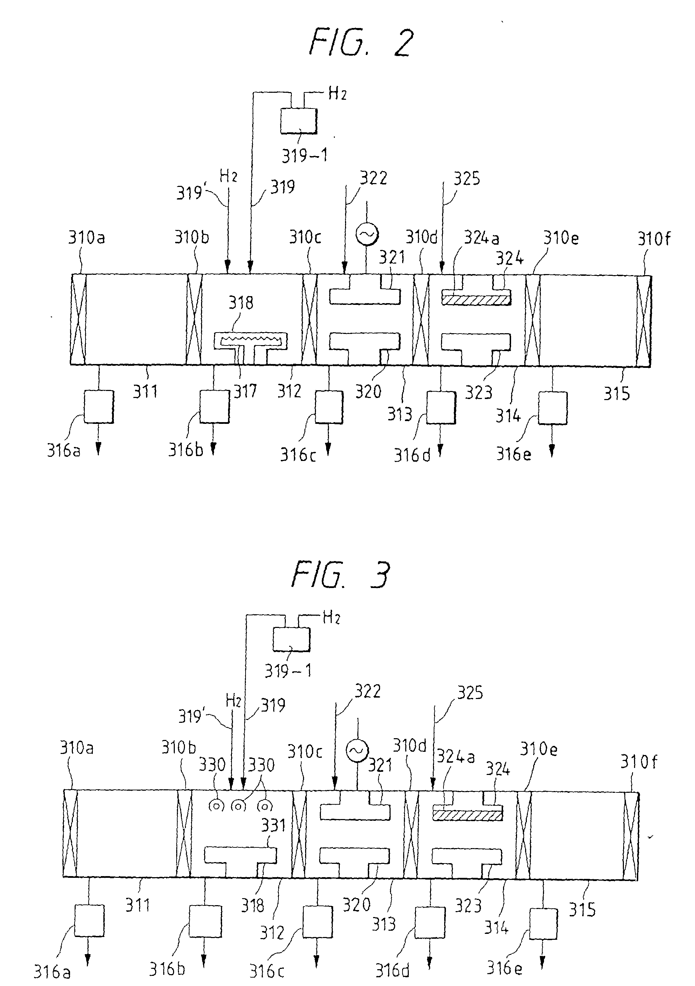

Figs. 2 to 4 schematically illustrate examples of continuous metal film forming apparatus suitable for executing the film forming method explained above.

As shown in Fig. 2, the apparatus is composed of a load lock chamber 311, a CVD reaction chamber (first film forming chamber) 312, an Rf etching chamber 313, a sputtering chamber (second film forming chamber) 314 and a load lock chamber 315, which are rendered sealable from the external atmosphere and mutually communicatable by means of gate valves 310a - 310f and can be respectively made vacuum or reduced in pressure by vacuum systems 316a - 316e. The load lock chamber 311 is used for eliminating the atmosphere of substrate and replacing it with H₂ prior to the deposition, in order to improve the throughout. The next CVD reaction chamber 312, for selective deposition onto the substrate under normal or reduced pressure, is provided therein with a substrate holder 318 with a resistance heater 317 for heating the substrate surface subjected to film formation at least within a temperature range of 200° - 450°C, and receives the source material gas such as of alkylaluminium hydride, which is gasified by bubbling with hydrogen in a bubbler 319-1, through a source material gas supply line 319, and hydrogen through a gas line 319'. The Rf etching chamber 313, for cleaning (etching) of the substrate surface in Ar atmosphere after the selective deposition, is provided therein with a substrate holder 320 capable of heating the substrate at least within a range of 100° - 250°C and an Rf etching electrode line 321, and is connected to an Ar gas supply line 322. The sputtering chamber 314, for non-selective deposition of a metal film by sputtering in Ar atmosphere, is provided therein with a substrate holder 323 to be heated at least within a range of 200° - 250°C and a target electrode 324 for mounting a sputtering target 324a, and is connected to an Ar gas supply line 325. The final load lock chamber 315, for adjustment of the substrate after metal film deposition and prior to the exposure to the external atmosphere, is designed to be capable of replacing the atmosphere with N₂.

Fig. 3 shows another example of a continuous metallic film forming apparatus, wherein the same components as those in Fig. 2 are represented by same numbers. The apparatus in Fig. 3 is different from that in Fig. 2 in that the substrate surface is directly heated by halogen lamps 330, and, for this purpose, the substrate holder 312 is provided with projections 331 for supporting the substrate in a floating state.

Direct heating of the substrate surface with such structure further increases the deposition speed as explained before.

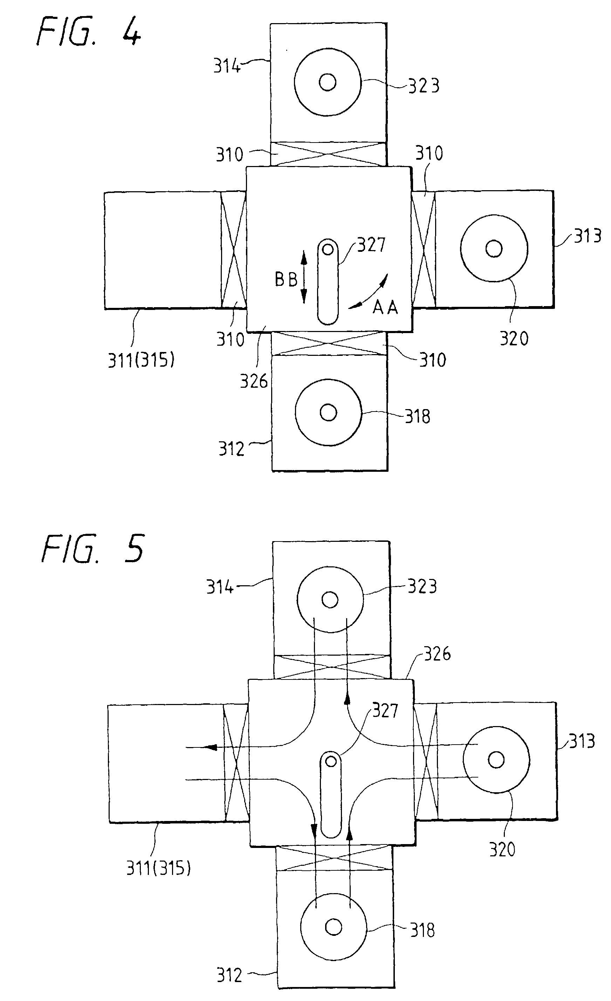

The continuous metallic film forming apparatus of the above-explained structure is equivalent, in practice, to a structure shown in Fig. 4, in which the load lock chamber 311, CVD reaction chamber 312, Rf etching chamber 313, sputtering chamber 314 and load lock chamber 315 are mutually combined by a transport chamber 326. In this structure, the load lock chamber 311 serves also as the chamber 315. In said transport chamber 326, there is provided an arm 327 constituting transport means, rotatable in both directions A-A and extendable and retractable in direction B-B, whereby the substrate can be transferred in succession from the load lock chamber 311 to the CVD reaction chamber 312, Rf etching chamber 313, sputtering chamber 314, and finally to the load lock chamber 315 without exposure to the external atmosphere, as indicated by arrows in Fig. 5.

### [Film forming process]

Now there will be explained the film forming process for forming the electrodes and wirings .

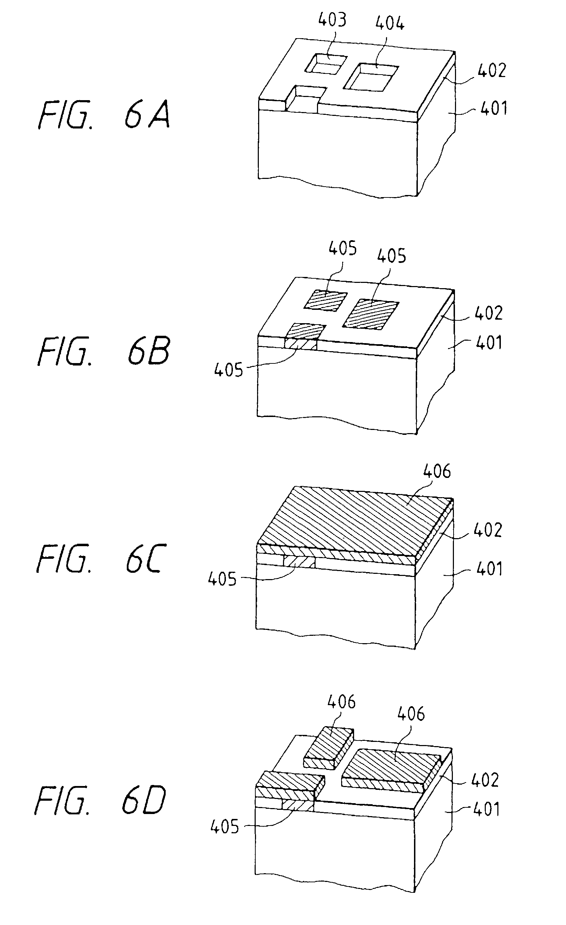

Fig. 6 illustrates a film forming procedure for forming the electrodes and wirings, in schematic perspective views.

At first the outline of the procedure will be described. A semiconductor substrate with an insulating film having apertures therein is placed in the film forming chamber, and the surface thereof is maintained for example at 250° - 450°C. Thermal CVD conducted in a mixed atmosphere of DMAH gas as alkylaluminium hydride and hydrogen gas causes selective deposition of Al on the semiconductor exposed in the apertures. There may naturally be conducted selective deposition of an aluminium metallic film, for example Al-Si,
by introduction for example of Si-containing gas, as explained before. Then a metal film composed solely or principally of Al is non-selectively formed by sputtering, on the selectively deposited Al and on the insulation film. Subsequently the non-selectively deposited metal film is patterned into the shape of desired wirings, thereby obtaining the electrodes and the wirings.

This procedure will be explained in greater detail with reference to Figs. 3 and 6. At first a substrate is prepared, consisting for example of a monocrystalline silicon wafer bearing thereon an insulation film, in which apertures of different sizes are formed.

Fig. 6A schematically shows a part of said substrate, wherein shown are a monocrystalline silicon substrate 401 constituting a conductive substrate; a thermal silicon oxide film 402 constituting an insulation film; and apertures 403, 404 of different sizes.

The formation of Al film, constituting a first wiring layer, on the substrate is conducted in the following manner, with the apparatus shown in Fig. 3.

At first the above-explained substrate is placed in the load lock chamber 311, in which a hydrogen atmosphere is established by introduction of hydrogen as explained before. Then the reaction chamber 312 is evacuated by the vacuum system 316b approximately to 1x10⁻⁶ Pa (1x10⁻⁸ Torr), though Al film formation is still possible with a higher pressure.

Then DMAH gas obtained by bubbling is supplied from the gas line 319, utilizing H₂ as the carrier gas.

Also hydrogen as the reaction gas is introduced from the second gas line 319', and the interior of the reaction chamber 312 is maintained at a predetermined pressure, by the adjustment of an unrepresented slow leak valve. A typical pressure is about 2.0x10² Pa (1.5 Torr). DMAH is introduced into the reaction chamber from the DMAH line, with a total pressure of about 2.0 x 10² Pa (1.5 Torr) and a DMAH partial pressure of about 6.7 x 10⁻¹ Pa (5.0 x 10⁻³ Torr). Then the halogen lamps 330 are energised to directly heat the wafer, thereby causing selective Al deposition.

After a predetermined deposition time, the DMAH supply is interrupted. Said deposition time is so selected that the Al film on Si (monocrystalline silicon substrate 1) becomes equally thick as Si0₂ (thermal silicon oxide film 2), and can be experimentally determined in advance.

In this process, the substrate surface is heated to ca. 270°C by direct heating, and the procedure explained above causes selective deposition of an Al film 405 in the aperture, as shown in Fig. 6B.

The foregoing is called a first film forming step for forming an electrode in an aperture.

After said first film forming step, the CVD reaction chamber 312 is evacuated, by the vacuum system 316b, to a pressure not exceeding 6.7 x 10⁻¹ Pa (5 x 10⁻³ Torr). Simultaneously the Rf etching chamber 313 is evacuated to a pressure not exceeding 6.7 x 10⁻⁴ Pa (5 x 10⁻⁶ Torr). After confirmation of said evacuations of the chambers, the gate valve 310c is opened, then the substrate is moved from the CVD reaction chamber 312 to the Rf etching chamber 313 by the transport means, and said gate valve is closed. The Rf etching chamber 313 is evacuated to a pressure not exceeding 10⁻⁴ Pa (10⁻⁶ Torr), and is then maintained in argon atmosphere of 10-10⁻¹ Pa (10⁻¹ - 10⁻³ Torr) by argon supply from the supply line 322. The substrate holder 320 is maintained at ca. 200°C, and an Rf power of 100 W is supplied to the Rf etching electrode 321 for about 60 seconds to generate an argon discharge in said chamber 313, whereby the substrate surface is etched with argon ions and the unnecessary surfacial layer of the CVD deposition film can be eliminated. The etch depth in this case is about 10 nm (100 Å), corresponding to the oxide film. Said surface etching of the CVD deposition film, conducted in the RF etching chamber, may be dispensed with since said surfacial layer is free from oxygen etc. as the substrate is transported in vacuum. In such case, the Rf etching chamber 313 may serve for varying the temperature within a short time if the temperature is significantly different between the CVD reaction chamber 312 and the sputtering chamber 314.

After said Rf etching, the argon supply is terminated, and the Rf etching chamber 313 is evacuated to 6.7 x 10⁻⁴ Pa (5 x 10⁻⁶ Torr). Then the sputtering chamber is also evacuated to 6.7 x 10⁻⁴ Pa (5 x 10⁻⁶ Torr) or lower, and the gate valve 310d is opened. The substrate is transferred from the Rf etching chamber 313 to the sputtering chamber 314 by the transport means, and said gate valve 310d is closed.

Subsequently the sputtering chamber is maintained at argon atmosphere of 10-10⁻¹ Pa (10⁻¹ - 10⁻³ Torr) as in the Rf etching chamber 313, and the substrate holder 323 is maintained at 200° - 250°C. Argon discharge is induced by a DC power of 5 - 10 kW to scrape the target of Al or Al-Si (Si: 0.5%) with argon ions, thereby depositing Al or Al-Si onto the substrate with a deposition speed of ca. 1000 nm/mm (10000 Å/min). This is a non-selective deposition step, and is called a second film forming step for forming wirings connected to the electrodes.

After the formation of the metal film of about 500 nm (5000 Å) on the substrate, the argon supply and the DC power application are terminated. The load lock chamber 311 is evacuated to a pressure of 6.1 x 10⁻¹ Pa (5 x 10⁻³ Torr) or lower, then the gate valve 310e is opened and the substrate is moved. After the gate valve 310e is closed, the load lock chamber 311 is supplied with nitrogen gas to the atmospheric pressure. Subsequently the gate valve 310f is opened and the substrate is taken out.

The second Al film deposition step explained above forms an Al film 406 on the SiO₂ film 402, as shown in Fig. 6C.

Subsequently said Al film 406 is patterned as shown in Fig. 6D to obtain the wirings of desired shape. A multi-layered wiring structure can be obtained by repetition of the above-explained process.

### [Experimental examples]

In the following there will be shown experimental results indicating the superiority of the above-explained Al-CVD method and the satisfactory quality of the Al film deposited by said method in the apertures.

There were prepared plural substrates, each consisting of an N-type monocrystalline silicon wafer, provided thereon with a thermally oxidised SiO₂ film of a thickness of 800 nm (8000 Å), in which apertures of different sizes from 0.25 x 0.25 µm to 100 x 100 µm were formed by patterning to expose the underlying monocrystalline silicon (samples 1-1).

These samples were subjected to the Al film formation by the Al-CVD method, employing DMAH as the raw material gas and hydrogen as the reaction gas, with a total pressure of 2.0 x 10² Pa (1.5 Torr) and a DMAH partial pressure of 6.7 x 10⁻¹ Pa (5.0 x 10⁻³ Torr), and with the substrate surface temperatures selected in a range of 200°C - 490°C by direct heating under the regulation of electric power supplied to the halogen lamps. The obtained results are summarised in Table 1.

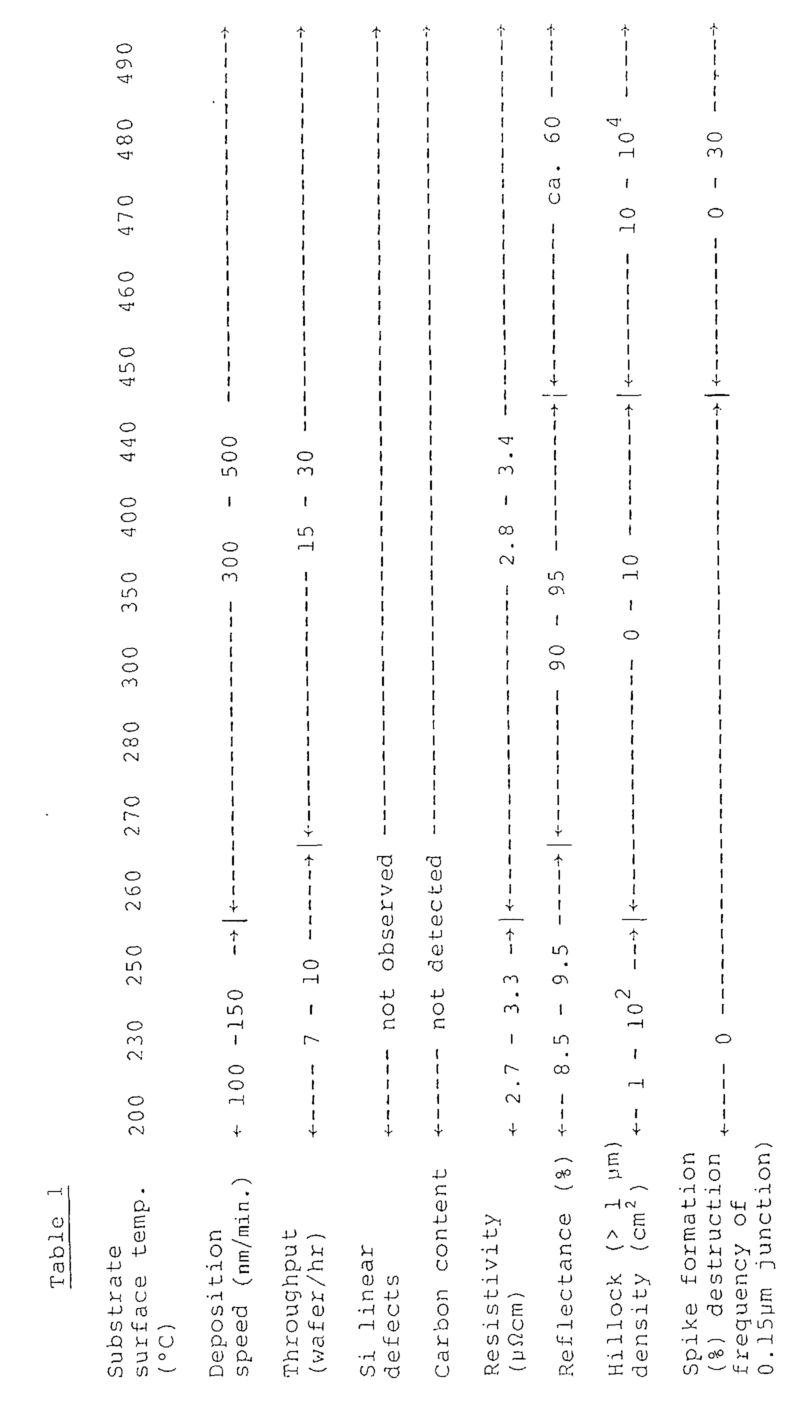

As will be apparent from Table 1, aluminium deposited in the apertures with a deposition speed as high as 300-500 nm/min (3000-5000 Å/min), at the substrate temperature of 260°C or higher obtained by direct heating.

The Al film in the apertures, obtained in a substrate surface temperature range of 260° - 440°C, showed satisfactory characteristics, with no carbon content, a resistivity of 2.8 - 3.4 µΩcm, a reflectance of 90 - 95 %, a hillock (≧ 1 µm) density of 0 - 10 cm², and an almost zero spike formation (frequency of destruction of 0.15 µm junction).

On the other hand, though the film quality obtained in a surface temperature range of 200° - 250°C was somewhat inferior to that obtained in the temperature range of 260° - 440°C, it is considerably better than that obtainable with the conventional technology, but the deposition speed could not exceed 100-150 nm/min (1000-1500 Å/ min.)and the throughput was in a relative low range of 7 - 10 wafer/hr.

At the substrate surface temperature equal to or higher than 450°C, the quality of the Al film in the apertures were deteriorated, with a reflectance of 60% or lower, a hillock (≧ 1 µm) density of 10 - 10⁴ cm ⁻² and an alloy spike formation of 0 - 30%.

In the following there will be explained how the above-explained method can be advantageously applied to the apertures such as contact holes or through-holes.

Said method can be advantageously applied to the contact holes or through-holes composed of the materials explained in the following.

The Al film formation was conducted on the following substrates (samples) under the same conditions as in the Al film formation on the above-mentioned samples 1-1.

Samples 1-2 were prepared by forming, on monocrystalline silicon constituting a first substrate surface material, a silicon oxide film constituting a second substrate surface material by means of CVD method, and forming apertures by a photolithographic process to locally expose the surface of monocrystalline silicon. The SiO₂ film was 800 nm (8000 Å) thick, and the apertures were sized from 0.25 x 0.25 µm to 100 x 100 µm. (Such sample will hereinafter be represented as "CVD SiO₂ (or simply SiO₂)/monocrystalline silicon".)

There were also preapred:
a sample 1-3 of boron-doped oxide film formed by normal pressure CVD (hereinafter written as BSG)/ monocrystalline silicon;
a sample 1-4 of phosphor-doped oxide film formed by normal pressure CVD (PSG) /monocrystalline silicon;
a sample 1-5 of boron- and phosphor-doped oxide film formed by normal pressure CVD (BSPG)/monocrystalline silicon;
a sample 1-6 of nitride film formed by plasma CVD (P-SiN)/monocrystalline silicon;
a sample 1-7 of thermal nitride film (T-SiN)/monocrystalline silicon;
a sample 1-8 of nitride film formed by low pressure CVD (LP-SiN)/monocrystalline silicon; and
a sample 1-9 of nitride film formed by ECD (ECR-SiN)/monocrystalline silicon.

Further, samples 1-11 to 1-179 were prepared by taking all the combinations of the first surface materials of 18 kinds and the second surface materials of 9 kinds shown in the following. The first surface materials employed were monocrystalline silicon (mono-Si), polycrystalline silicon (poly-Si), amorphous silicon (a-Si), tungsten (W), molybdenum (Mo), tantalum (Ta), tungsten silicide (WSi), titanium silicide (TiSi) , aluminium (Al), aluminium silicon (Al-Si), titanium aluminium (Al-Ti), titanium nitride (Ti-N), copper (Cu), aluminium silicon copper (Al-Si-Cu), aluminium palladium (Al-Pd), titanium (Ti), molybdenum silicide (Mo-Si), and tantalum silicide (Ta-Si). The secpnd substrate surface materials employed were T-SiO₂, SiO₂, BSG, PSG, BPSG, P-SiN, T-SiN, LP-SiN and ECR-SiN. In all these samples, there could be obtained satisfactory Al films comparable to those in the aforementioned samples 1-1.

Subsequently, the Al was non-selectively deposited by sputtering on the substrates subjected to the selective Al deposition as explained above, and was then patterned.

The Al film obtained by sputtering and the selectively deposited Al film in the apertures showed electrically and mechanically satisfactory contact, because of the improved surface state of the Al film in the apertures.

### Example

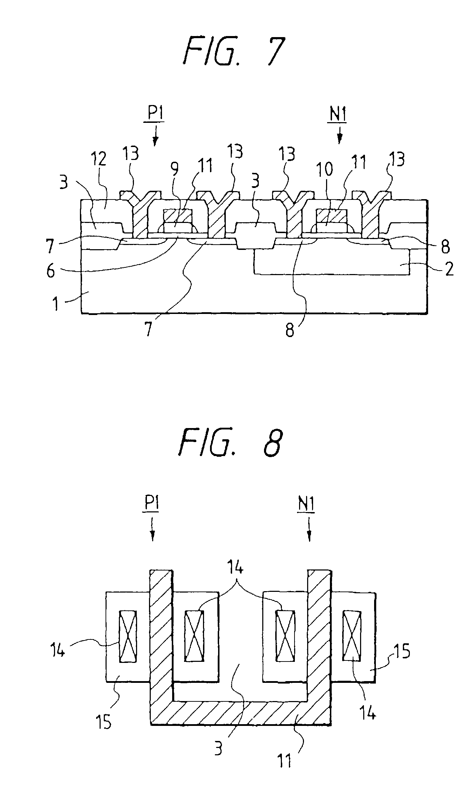

Figs. 7 and 8 are respectively a schematic cross-sectional view and a plan view of complementary FETs consisting of a P-channel IGFET (P1) and an N-channel IGFET (N1) formed on an n-type silicon semiconductor substrate 1. More detailedly, the P-channel IGFET (P1) includes a gate oxide film 6, source-drain areas 7, a p-type polysilicon gate electrode 9, an Al-Si film 11 formed by the aforementioned selective deposition on the polysilicon gate electrode 9, an interlayer insulation film 12, and source-drain electrodes 13 consisting of Al-Si deposited in contact holes formed in said insulation film 12. Similarly the N-channel IGFET (N1) includes a p-type buried layer 2, source-drain areas 8, n-type polysilicon gate electrode 10, an al-Si film 11 selectively deposited thereon, and source-drain electrodes 13. The P-channel and N-channel IGFETs are electrically separated by a separation area 3. The polysilicon areas 9 and 11 are parts, doped in different conductivity types, of a continuous patterned polysilicon layer, and the Al-Si film 11 is selectively deposited on the entire area of said polysilicon layer.

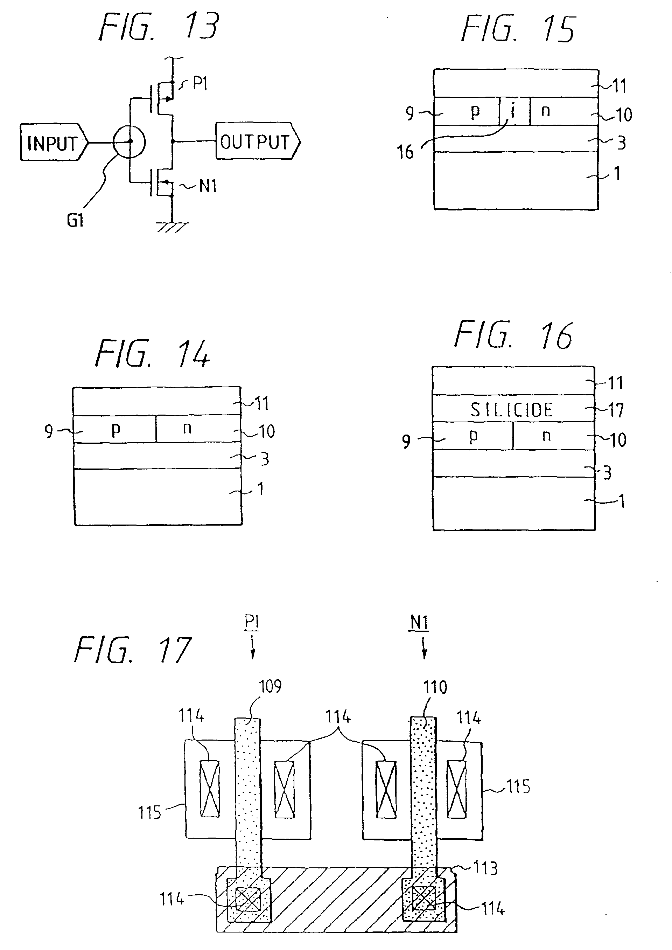

In Fig. 8, 14 indicates contact areas of the source-drain electrodes, and 15 indicates the boundary between the field oxide film 3 and the transistor active area. The source and drain electrodes 14 are preferably formed also by the selective deposition method explained above.

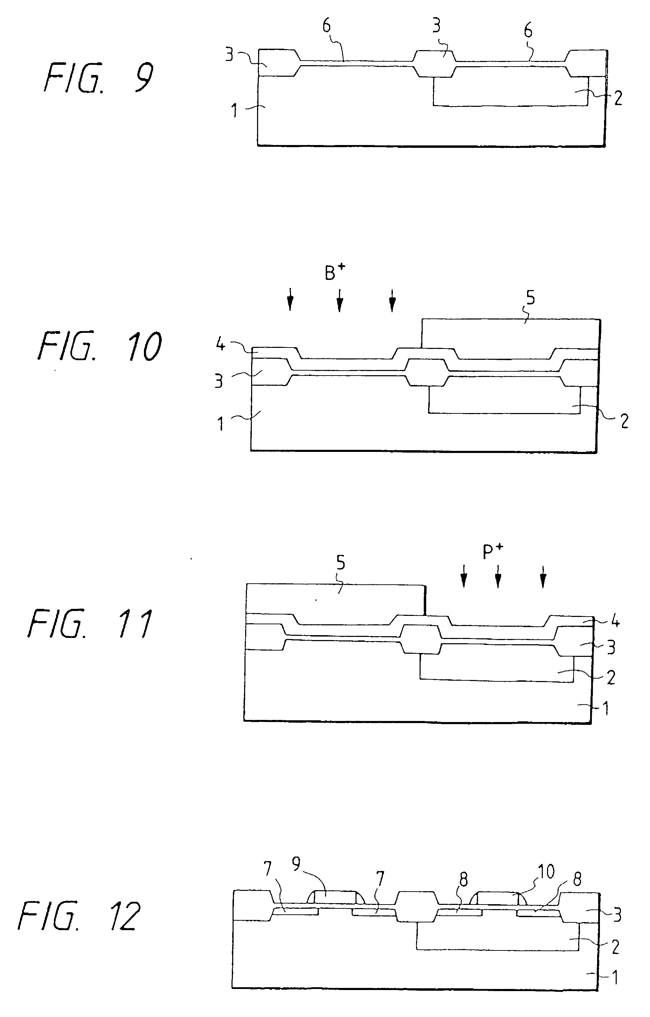

Now reference is made to Figs. 9 to 12, for explaining the method for producing the MOSFET shown in Figs. 7 and 8.

At first a predetermined area of an n-type substrate 1 with an impurity concentration of 10¹⁴ - 10¹⁶ cm⁻³ was subjected to implantation of B⁺ ions with a dose of 10¹² - 10¹³ cm⁻², followed by a heat treatment at 1100 - 1200°C to form a p-well 2. Then a separation area 3 was formed by a LOCOS process, and a gate oxide film 6 of a thickness of 10-35 nm (100-350 Å) was formed (Fig.9). Subsequently ion implantation was conducted in ordinary manner, in order to control the threshold voltage and the source-drain voltage resistance.

Then a polysilicon layer 4 of a thickness of 150-450nm (1500 - 4500 Å)was deposited by LPCVD, then an area where the N-channel IGFET was to be formed was covered with photoresist 5, and B⁺ ions were implanted with a dose of 10¹⁴ - 3 x 10¹⁵ cm⁻² only in the area of the P-channel IGFET (Fig.10). The photoresist in the N-channel IGFET area was stripped, the P-channel IGFET area was newly covered with photoresist 5; and P⁺ ions were implanted with a dose of 5 x 10¹⁴ - 10¹⁶ cm⁻² (Fig.11). Subsequently heat treatment was conducted at 900 - 1000°C.

After patterning of the polysilicon, the surface and the lateral faces of polysilicon layers 9, 10 were oxidised. Then BF₂⁺ ions were implanted with a dose of 10¹⁵ - 3 x 10¹⁵ cm⁻² in order to form the source-drain areas 7 of the P-channel IGFET, and As⁺ ions were implanted with a dose of 10¹⁵ - 10¹⁶ cm⁻² in order to form the source-drain areas 8 of the N-channel IGFET. Thus the source-drain areas can be formed in self-aligning manner. Then thermal treatment was conducted at 800-1000°C, and the surface oxide film of the polysilicon areas 9, 10 was eliminated by etch back (Fig.12).

On the thus treated semiconductor substrate, the polysilicon layers 9, 10 and the oxide film exist together as shown in Fig.12. Among the above-explained Al-CVD method, a low pressure CVD employing DMAH, Si₂H₆ and hydrogen was conducted to selectively deposit Al-Si film solely on the polysilicon layers 9, 10, thereby forming a multi-layered film of polysilicon and Al-Si.

Subsequently, the complementary IGFET circuit shown in Fig. 7 was prepared by depositing the interlayer insulation film 12 by CVD, opening contact holes on the source-drain areas of the IGFETs, and depositing Al-Si 13 in said contact holes by selective deposition. A multi-layered wiring structure may be formed by forming a second interlayer insulation film on the structure shown in Fig.7. This can be achieved by opening through-holes reaching the gate metal electrodes 11 or source-drain electrodes 13 in said second insulation film, filling said through-holes with Al-Si or Al by selective deposition, forming for example an Al-Si film on the second interlayer insulation film by a non-selective depositing method such as sputtering, effecting a patterning step in ordinary manner and forming a passivation film.

The complementary IGFET circuit thus prepared can be utilised as an inverter as shown in Fig. 13. In Fig. 13, an area below the gate electrode of the P-channel IGFET is composed of p-polysilicon, while an area below the gate electrode of the N-channel IGFET is composed of n-polysilicon.

Fig. 14 is a cross-sectional view of a gate wiring G1 of PMOSFET and NMOSFET in Fig. 13. In the present example the p-area 9 and the n-area 10 in polysilicon are in mutual contact, but there may be formed an undoped (i-type) area 16 therebetween as shown in Fig. 15.

As the above-explained selective Al-Si depositing method can selectively deposit Al-Si not only on silicon but also on silicides such as WSi₂, MoSi₂, TiSi₂ or TaSi₂, the wiring may also be formed, as shown in Fig. 16, by forming a silicide 17 on the polysilicon layers, 9, 10 and selectively depositing an Al-Si film 11 thereon.

The ion implantation into polysilicon and the ion implantation for source-drain formation for MOSFET in the present example are conducted in separate steps, but these ion implantations may be in a same step.

It is furthermore possible to use a multi-layered film of polysilicon and Al-Si for the lead electrodes for the source and drain regions of the IGFETs, as in the gate electrodes.

Fig. 17 shows, for the purpose of comparison, a CMOSFET prepared by a conventional process, in a plan view. At the sides of P-channel IGFET (P1) and N-channel IGFET (N1), there are respectively formed polysilicon gates 109, 110 doped in p-type and n-type, and said gates are connected to an upper Al layer 113 through contacts 114 in through-holes formed in the interlayer insulation film. In such conventional example, a polysilicon wiring with a thickness of 400 nm (4000 Å), a length of 10 *µ*m and a width of 2 *µ*m had a resistance of 50 - 200 Ω. On the other hand, the wiring of the present example with a polysilicon layer of a thickness of 200 nm (2000 Å) and an Al-Si (or Al) layer with a thickness of 400 nm (4000 Å) significantly reduces the resistance to 1 Ω or less. Consequently the switching speed of the complementary IGFET inverter can be significantly increased. Also, since Al-Si is directly deposited on a single polysilicon layer including the portions of different conductivity types, the connecting part between Al-Si and polysilicon, as in the conventional structure shown in Fig. 17, can be eliminated. It is therefore possible to eliminate unnecessary areas in the circuit layer. The production yield is not deteriorated by this fact, and the design freedom is increased considerably since n⁺-polysilicon and p⁺-polysilicon can be freely connected in the circuit. This fact contributes greatly to an improvement in circuit performance and a reduction of the period required for circuit development.

In the foregoing example, an Al-Si film is selectively deposited on polysilicon. However, it is also possible to convert polysilicon into monocrystralline state by laser annealing or electron beam annealing, and to selectively deposit the Al-Si film on such monocrystalline area. As an Al-Si film of improved crystallinity can be grown on monocrystalline silicon, the migration resistance can be further improved.

Bipolar transistors and IGFETS may be formed on the same substrate.

As explained in the foregoing, wiring resistance can be reduced and satisfactory matching can be achieved in a complementary circuit, by doping a silicon layer, for example a polysilicon layer, with impurities of different conductivity types, and selectively depositing an aluminium metallic film thereon.

Also polysilicon, for example, may be used for both electrodes and wiring, thereby leading to an improvement in production yield, a reduction in chip size and improvement in the level of integration.

Also the possibility of connection of n⁺-polysilicon and p⁺-polysilicon in the circuit significantly increases the freedom of circuit design, thereby contributing to an improvement in circuit performance and a reduction in the period required for device development.

## Claims

1. A method of producing a silicon semiconductor integrated circuit having complementary P-channel and N-channel insulated gate field effect transistors (IGFETs) (P1, N1) defined on a silicon semiconductor substrate (1), the insulated gate electrodes (9,10) of those transistors (P1,N1) being of opposite conductivity type doped polycrystalline or monocrystalline silicon semiconductor materials, which insulated gate electrodes (9,10) extend and meet at a semiconductor pn or pin junction, there being a patterned shunt layer (11) of a thin film metallic material provided over the entire area of said insulated gate electrodes (9,10), which method comprises the following steps:
providing the silicon semiconductor substrate (1) and a gate insulation film (6) on its surface,
producing a polycrystalline or monocrystalline silicon semiconductor layer (9,10) on said gate insulation film (6), which crystalline silicon semiconductor layer (9,10) is patterned and doped to define the adjoined gate electrodes (9,10) of respective opposite conductivity types; and
forming the patterned shunt layer (11) of thin film metallic material over the entire area of said gate electrodes (9,10);
which method is characterised in that:
said step of forming the patterned shunt layer (11) is performed by a selective chemical vapour deposition process wherein an aluminium metallic material is deposited selectively over the entire area of said adjoined gate electrodes (9,10) by exposing the adjoined gate electrodes (9,10), and the surface of said gate insulation film (6) surrounding said adjoined gate electrodes (9,10), to a chemical vapour ambient comprising an alkyl aluminium hydride, selected from either monomethylaluminium hydride or dimethylaluminium hydride, as aluminium source, and hydrogen, introduced from an external source, which chemical vapour ambient is at a temperature which is at least equal to the decomposition temperature of said alkyl aluminium hydride but is lower than 450°C.

2. A method according to claim 1 wherein the step of selectively depositing the aluminium metallic material is preceded by a step of forming a layer of a silicide on the entire area of the adjoined gate electrodes (9,10).

3. A method according to claim 1 wherein the selectively deposited aluminium metallic material is of aluminium silicide or an aluminium mixed silicide and said chemical vapour ambient comprises dimethylaluminium hydride, hydrogen and a gas containing silicon as silicon source.

4. A method according to any preceding claim wherein the source and drain regions (7,8) of the respective P-channel and N-channel transistors (P1,N1) are formed by respective ion implantation steps; and
in the step of producing the adjoined gate electrodes (9,10) of respective opposite conductivity types, the crystalline silicon semiconductor layer (9,10) is first patterned and then the resulting patterned semiconductor layer (9,10) is doped in the same respective ion implantation steps that are performed to form said source and drain regions (7,8) of the respective P-channel and N-channel transistors (P1,N1).

5. A method according to any preceding claim including completing steps of:
forming an insulating layer (12) extending over said adjoined gate electrodes (9,10) and shunt layer (11); and
forming electrode contacts (13) in ohmic contact with the source and drain regions of the respective P-channel and N-channel transistors (P1,N1) via apertures provided in said insulating layer (12).

## Patentansprüche

1. Verfahren zur Herstellung einer integrierten Siliziumhalbleiterschaltung mit komplementären p-Kanal- und n-Kanal-Feldeffekttransistoren mit isoliertem Gate (IGFET) (P1, N1), die auf einem Siliziumhalbleitersubstrat (1) definiert ist, wobei die isolierten Gateelektroden (9, 10) dieser Transistoren (P1, N1) mit entgegengesetzten Ladungsträgerarten dotierte polykristalline oder monokristalline Siliziumhalbleiterwerkstoffe umfassen, dabei erstrecken sich die isolierten Gateelektroden (9, 10) bis zu einem pn- oder pin-Halbleiterübergang und treffen sich dort, und es ist eine strukturierte Stromableitungsschicht (11) aus einem metallischen Dünnschichtwerkstoff über der gesamten Fläche der isolierten Gateelektroden (9, 10) bereitgestellt, das Verfahren umfasst dabei die Schritte:
Bereitstellen des Siliziumhalbleitersubstrats (1) und einer Gateisolationsschicht (6) auf dessen Oberfläche,
Erzeugen einer polykristallinen oder monokristallinen Siliziumhalbleiterschicht (9, 10) auf der Gateisolationsschicht (6), wobei die kristalline Siliziumhalbleiterschicht (9, 10) zur Definierung der angrenzenden Gateelektroden (9, 10) von jeweils entgegengesetzter Ladungsträgerart strukturiert und dotiert wird; und
Ausbilden der strukturierten Stromableitungsschicht (11) aus dem metallischen Dünnschichtwerkstoff über der gesamten Fläche der Gateelektroden (9, 10);
das Verfahren ist dadurch gekennzeichnet, dass:
der Schritt zum Ausbilden der strukturierten Stromableitungsschicht (11) durch einen selektiven chemischen Gasphasenabscheidungsvorgang durchgeführt wird, wobei ein metallischer Aluminiumwerkstoff über der gesamten Fläche der angrenzenden Gateelektroden (9, 10) selektiv abgeschieden wird, indem die angrenzenden Gateelektroden (9, 10) und die diese angrenzenden Gateelektroden (9, 10) umgebende Oberfläche der Gateisolationsschicht (6) einer chemischen Gasphasenumgebung mit einem Alkylaluminiumhydrid aus entweder Monomethylaluminiumhydrid oder Dimethylaluminiumhydrid als Aluminiumquelle und mit aus einer externen Quelle zugeführtem Wasserstoff ausgesetzt werden, dabei weist die chemische Gasphasenumgebung eine Temperatur auf, die zumindest gleich der Zersetzungstemperatur des Alkylaluminiumhydrids aber geringer als 450 °C ist.

2. Verfahren nach Anspruch 1, wobei dem Schritt zur selektiven Abscheidung des metallischen Aluminiumwerkstoffs ein Schritt zur Ausbildung einer Silizidschicht auf der gesamten Fläche der angrenzenden Gateelektroden (9, 10) vorausgeht.

3. Verfahren nach Anspruch 1, wobei der selektiv abgeschiedene metallische Aluminiumwerkstoff aus Aluminiumsilizid oder einem mit Aluminium gemischten Silizid ist, und die chemische Gasphasenumgebung Dimethylaluminiumhydrid, Wasserstoff und ein Silizium enthaltendes Gas als Siliziumquelle umfasst.

4. Verfahren nach einem der vorstehenden Ansprüche, wobei die Source- und Drainbereiche (7, 8) der jeweiligen p-Kanal- und n-Kanal-Transistoren (P1, N1) durch jeweilige Ionenimplantationsschritte ausgebildet sind; und
bei dem Schritt zur Erzeugung der angrenzenden Gateelektroden (9, 10) von jeweils entgegengesetzter Ladungsträgerart die kristalline Siliziumhalbleiterschicht (9, 10) zunächst strukturiert wird, und sodann die resultierende strukturierte Halbleiterschicht (9, 10) bei denselben jeweiligen Ionenimplantationsschritten dotiert wird, die zur Ausbildung der Source- und Drainbereiche (7, 8) der jeweiligen p-Kanal- und N-Kanal-Transistoren (P1, N1) durchgeführt werden.

5. Verfahren nach einem der vorstehenden Ansprüche unter Durchführung der Schritte:
Ausbilden einer isolierenden Schicht (12), die sich über die angrenzenden Gateelektroden (9, 10) und die Stromableitungsschicht (11) erstrecken; und
Ausbilden von Elektrodenanschlüssen (13) in ohmschem Kontakt zu den Source- und Drainbereichen der jeweiligen p-Kanal- und n-Kanal-Transistoren (P1, N1) über in der isolierenden Schicht (12) bereitgestellte Aperturen.

## Revendications

1. Procédé de production d'un circuit intégré à semi-conducteur de silicium ayant des transistors à effet de champ à grille isolée, à canal P et à canal N (IGFETs) complémentaires (P1, N1), définis sur un substrat de semi-conducteur de silicium (1), les électrodes de grille isolées (9, 10) de ces transistors (P1, N1) étant constituées de matériaux semi-conducteurs de silicium polycristallin ou monocristallin dopé du type à conductivité opposée, lesquelles électrodes de grille isolées (9, 10) se prolongent et se rencontrent à une jonction de semi-conducteur pn ou pin, une couche de dérivation (11) portant des motifs, constituée d'un film mince de matériau métallique étant ménagée sur toute la surface desdites électrodes de grille isolées (9, 10), lequel procédé comprend les étapes suivantes :
disposition du substrat de semi-conducteur de silicium (1) et d'un film d'isolation de grille (6) sur sa surface ;
production d'une couche de semi-conducteur de silicium polycristallin ou monocristallin (9, 10) sur ledit film d'isolation de grille (6), laquelle couche de semi-conducteur de silicium cristallin (9, 10) est revêtue de motifs et dopée pour définir les électrodes de grilles adjacentes (9, 10) de types de conductivité opposés respectifs ; et
formation de la couche de dérivation revêtue de motifs (11) d'un matériau métallique en film mince sur toute la surface desdites électrodes de grille (9, 10) ;
lequel procédé est caractérisé en ce que :
ladite étape de formation de la couche de dérivation revêtue de motifs (11) est effectuée par un procédé de dépôt chimique en phase vapeur sélectif dans lequel un matériau métallique d'aluminium est déposé sélectivement sur toute la surface desdites électrodes de grille adjointes (9, 10) en exposant les électrodes de grille adjointes (9, 10), et la surface dudit film d'isolation de grille (6) entourant ces électrodes de grille adjointes (9, 10), à une ambiance de vapeur chimique comprenant un hydrure d'alkylaluminium, choisi parmi l'hydrure de monométhylaluminium et l'hydrure de diméthylaluminium, comme source d'aluminium, et de l'hydrogène, introduit à partir d'une source externe, laquelle ambiance de vapeur chimique est à une température qui est au moins égale à la température de décomposition dudit hydrure d'alkylaluminium mais est inférieure à 450°C.

2. Procédé selon la revendication 1, dans lequel l'étape de dépôt sélectif du matériau métallique d'aluminium est précédée d'une étape de formation d'une couche de siliciure sur toute la surface des électrodes de grille (9, 10) adjacentes.

3. Procédé selon la revendication 1, dans lequel le matériau métallique d'aluminium déposé sélectivement est constitué de siliciure d'aluminium ou d'un siliciure mixte d'aluminium et ladite ambiance de vapeur chimique comprend de l'hydrure de diméthylaluminium, de l'hydrogène et un gaz contenant du silicium comme source de silicium.

4. Procédé selon l'une quelconque des revendications précédentes, dans lequel les régions source et drain (7, 8) des transistors à canal P et à canal N (P1, N1) respectifs sont formées par des étapes d'implantation d'ion respectives ; et
dans l'étape de production des électrodes de grille adjointes (9, 10) de types de conductivité opposés respectifs, la couche de semi-conducteur de silicium cristallin (9, 10) est d'abord revêtue de motifs puis la couche de semi-conducteur munie de motifs obtenue (9, 10) est dopée lors des mêmes étapes d'implantation d'ions respectives que celles effectuées pour former lesdites régions source et drain (7, 8) des transistors à canal P et à canal N (P1, N1) respectifs.

5. Procédé selon l'une quelconque des revendications précédentes, comprenant les étapes complémentaires de :
formation d'une couche isolante (12) s'étendant sur lesdites électrodes de grille adjointes (9, 10) et couche de dérivation (11) ; et
formation de contacts d'électrodes (13) en contact ohmique avec les régions source et drain des transistors à canal P et à canal N respectifs (P,N) via des ouvertures pratiquées dans ladite couche isolante (12).
